Europäisches Patentamt

European Patent Office

Office européen des brevets

(19)

(11) Veröffentlichungsnummer: **0 169 325**
**B1**

(12) **EUROPÄISCHE PATENTSCHRIFT**

(45) Veröffentlichungstag der Patentschrift:
13.07.88

(21) Anmeldenummer: 85106071.5

(22) Anmeldetag: 17.05.85

(51) Int. Cl.⁴: **C 03 B 37/014, C 23 C 16/44**

(54) **Verfahren zur Herstellung eines Aerosolstromes.**

(30) Priorität: 25.07.84 DE 3427323

(43) Veröffentlichungstag der Anmeldung:
29.01.86 Patentblatt 86/5

(45) Bekanntmachung des Hinweises auf die Patenterteilung:
13.07.88 Patentblatt 88/28

(84) Benannte Vertragsstaaten:
AT BE CH DE FR GB IT LI NL SE

(56) Entgegenhaltungen:
FR - A - 2 333 628
FR - A - 2 496 231
GB - A - 2 118 320
US - A - 4 148 621

(73) Patentinhaber: Licentia Patent-Verwaltungs-GmbH,
Theodor-Stern-Kai 1, D-6000 Frankfurt/Main 70 (DE)

(72) Erfinder: Kuisl, Max, Dr.rer.nat., Binsenweiherweg 9,
D-7900 Ulm (DE)

(74) Vertreter: Schulze, Harald Rudolf, Dipl.-Ing. et al,
Licentia Patent-Verwaltungs-GmbH
Theodor-Stern-Kai 1, D-6000 Frankfurt/Main 70 (DE)

## Beschreibung

Die Erfindung betrifft ein Verfahren zur Herstellung eines Aerosolstromes nach dem Oberbegriff des Patentanspruchs 1.

Ein derartiges Verfahren ist bekannt aus der französischen Offenlegungsschrift FR-A-2 496 231. Das dort beschriebene Verfahren betrifft ein sogenanntes VAD («vertical axial deposition»)-Verfahren zur Herstellung einer Vorform für einen Lichtwellenleiter. Dabei wird ein lotrecht stehender Brenner benutzt, dem neben brennbaren Gasen auch glasbildende Gase und/oder Dämpfe zugeführt werden. Durch Flammenhydrolyse entsteht ein $SiO_2$-Partikel haltiger Aerosolstrom. Die $SiO_2$-Partikel werden auf der Stirnfläche eines sich drehenden zylinderförmigen Körpers abgeschieden, der sich oberhalb des Brenners befindet. Der Brenner besteht aus Rohren mit unterschiedlich grossen Durchmessern, die konzentrisch angeordnet sind. An dem oberen Ende des Brenners ist also eine Ringdüse vorhanden, an welcher die Flamme erzeugt wird. Zur Vermeidung einer unerwünschten Abscheidung von $SiO_2$-Partikeln, z.B. an der Ringdüse, ist an dem äusseren Rohr des Brenners, oberhalb der Ringdüse, ein weiteres heizbares Führungsrohr angebracht. Dadurch wird die Flamme geführt, stabilisiert und eine unerwünschte Abscheidung von $SiO_2$-Partikel an Teilen des Brenners eingeschränkt.

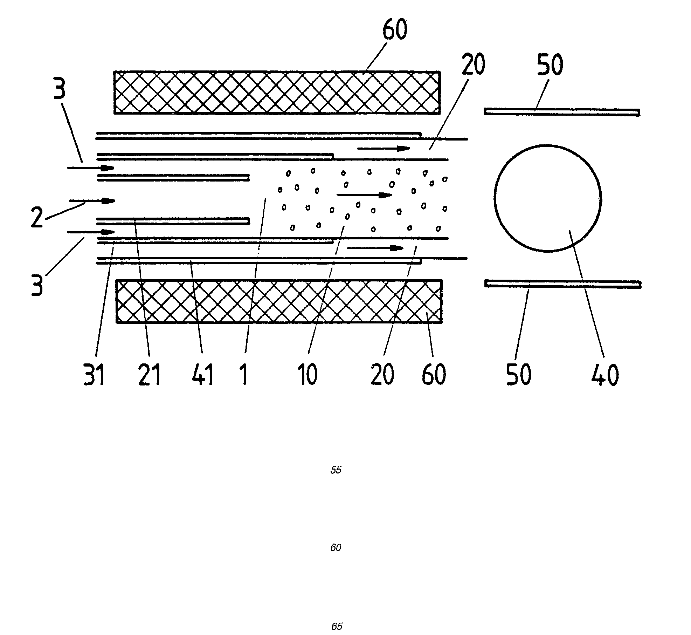

In der nicht veröffentlichten europäischen Offenlegungsschrift EP-A-0 134 507, die unter Artikel 54 (3) EPÜ fällt, welche der nicht vorveröffentlichten deutschen Patentanmeldung P 33 26 043.5 entspricht, ist ein flammenfrei arbeitendes Verfahren zur Herstellung eines Aerosolstromes beschrieben, der insbesondere zur Herstellung einer Vorform für einen Lichtwellenleiter verwendbar ist. Dieses Verfahren wird im folgenden anhand der Figur näher erläutert. Durch die im wesentlichen konzentrisch angeordneten Rohre 21, 31, 41, deren Querschnitt der Verwendung des zu erzeugenden Aerosolstromes angepasst ist, werden laminar strömende gas- und/oder dampfförmige Komponenten 2, 3 geleitet sowie ein aerosolfreier Dampf- und/oder Gasstrom 20. In einem Reaktionsraum 1, der durch einen Ofen 60 erhitzt wird, entsteht dann ein Aerosolstrom 10, welcher durch den Dampf- und/oder Gasstrom 20 zu einem zu beschichtenden Körper 40 geführt wird. Auf dem Körper 40 werden die im Aerosolstrom 10 enthaltenen Partikel niedergeschlagen. Dieses wird unterstützt durch aerodynamisch ausgebildete Leitkörper 50. Insbesondere zur Herstellung einer Vorform für einen Lichtwellenleiter aus Quarzglas ist es zweckmässig, zwischen dem Körper 40 und den Leitkörpern 50 ein inhomogenes elektrisches Feld zu erzeugen, durch das eine Abscheidung von dotierten und/oder undotierten Quarzglaspartikeln zusätzlich unterstützt wird.

Der Erfindung liegt die Aufgabe zugrunde, das bekannte Verfahren so zu verbessern, dass die unerwünschte Abscheidung von $SiO_2$-Partikeln an

den Wandungen des Reaktionsraumes weiter eingeschränkt wird.

Diese Aufgabe wird gelöst durch die im kennzeichnenden Teil des Patentanspruchs 1 angegebenen Merkmale. Weitere Ausgestaltungen und Weiterbildungen sind den Unteransprüchen entnehmbar.

Die Erfindung beruht auf der Erkenntnis, dass kleine Teilchen (Partikel) mit Hilfe eines Temperaturgefälles bewegtwerden können. Ein derartiger Vorgang ist bekannt unter der Bezeichnung Thermophorese. Die Bezeichnung Thermophorese ist eine zusammenfassende Bezeichnung für temperaturabhängige Bewegungen, wie z.B. Thermodiffusion sowie Thermoosmose.

Aus der EP-A-0 134 507 (deutsche Patentanmeldung P 33 26 043.5) geht hervor, dass unerwünschte Abscheidungen der Partikel des Aerosolstromes 10 vermieden werden durch den im wesentlichen aerosolfreien Dampf- und/oder Gasstrom 20, welcher den Aerosolstrom 10 umgibt und diesen führt. Diese Wirkung ist durch Thermophorese unterstützbar. Wird beispielsweise der aerosolfreie Dampf- und/oder Gasstrom 20 und/oder die diesen umgebenden Wandungen des Rohres 41 auf eine höhere Temperatur erhitzt als diejenige des Aerosolstroms 10, so entstehen radial gerichtete Kräfte, welche die im Aerosolstrom enthaltenen Partikel zur Längsachse des Aerosolstroms 10 hin bewegen. Eine störende Beschichtung insbesondere der Wandung des Reaktionsraumes 1, eventueller Düsen sowie der Leitkörper 50 wird vermieden.

Bei dem im Hauptpatent erwähnten Beispiel zur Erzeugung von $SiO_2$-Partikel aus gasförmigen $SiCl_4$ und gasförmigem $H_2O$ ist es beispielsweise möglich, die Komponenten $SiCl_4$ und $H_2O$ einzeln auf die erforderliche Reaktionstemperatur von ungefähr 800–1000 °C zu erwärmen und die erwärmten Komponenten dann im Reaktionsraum 1 zu vermischen, so dass der Aerosolstrom 10 entsteht. Der dargestellte Ofen 60 dient dann lediglich zum Erwärmen der Wandungen der Rohre 21, 31, 41 und/oder des Dampf- und/oder Gasstromes 20 auf eine gegenüber der Reaktionstemperatur höhere Temperatur von z.B. 1200 °C.

Insbesondere für Lichtwellenleiter mit polarisationserhaltenden optischen Eigenschaften ist es erforderlich, eine optisch nicht rotationssymmetrische $SiO_2$-Abscheidung vorzunehmen auf einem stabförmigen Körper 40, z.B. auf einem bereits vorhandenen Vorformkörper von ungefähr 1 m Länge und 5 cm Durchmesser. Dazu ist es erforderlich, die Abscheidung in Abhängigkeit vom Drehwinkel des Körpers 40 zu steuern und/oder zu regeln. Dieses ist auf vielfältige Weise möglich, z.B. durch eine ungleichförmige Drehung des Körpers 40 und/oder durch eine ungleichmässige Dotiermittelzugabe zum $SiCl_4$ und/oder durch eine Änderung des erwähnten elektrischen Feldes. Auf diese Weise kann beispielsweise ein Lichtwellenleiter erzeugt werden mit einem optisch wirksamen elliptischen Querschnitt.

## Patentansprüche

1. Verfahren zur Herstellung eines Aerosolstromes, insbesondere eines SiO$_2$-Partikel haltigen Aerosolstromes zur Herstellung einer Vorform für einen Lichtwellenleiter, bei welchem Verfahren

– die zur Herstellung des Aerosolstromes erforderlichen gas- und/oder dampfförmigen Reaktionspartner in mehreren konzentrisch angeordneten Röhren einem Reaktionsraum zugeführt werden und

– die Wand des Reaktionsraumes derart erhitzt wird, dass daran eine Ablagerung der in dem Aerosolstrom enthaltenden Partikel vermieden wird, dadurch gekennzeichnet,

– dass mindestens ein Bestandteil der gas- und/oder dampfförmigen Reaktionspartner vor dem Einleiten in den Reaktionsraum (1) auf eine Temperatur erhitzt wird, die im wesentlichen der Reaktionstemperatur zur Herstellung des Aerosols entspricht,

– dass das Aerosol durch eine flammenfreie chemische Reaktion erzeugt wird,

– dass der entstandene Aerosolstrom durch einen im wesentlichen aerosolfreien, Gas- und/oder Dampfstrom (20) geführt wird und

– dass der im wesentlichen aerosolfreie Gas- und/oder Dampfstrom (20) auf eine gegenüber der Reaktionstemperatur höhere Temperatur erhitzt wird.

2. Verfahren zur Herstellung eines Aerosolstromes nach Anspruch 1, dadurch gekennzeichnet, dass die höhere Temperatur des aerosolfreien Gas- und/oder Dampfstromes (20) auf einen Wert eingestellt wird, bei welchem die Partikel des Aerosols durch Thermophorese derart innerhalb des Aerosolstromes (10) gehalten werden, dass eine Abscheidung der Partikel an unerwünschten Stellen vermieden wird.

3. Verfahren zur Herstellung eines Aerosolstromes nach Anspruch 1 oder Anspruch 2, dadurch gekennzeichnet, dass die den Aerosolstrom (10) und/oder den aerosolfreien Gas- und/oder Dampfstrom (20) umgebenden Wandungen auf die höhere Temperatur erhitzt werden derart, dass die Partikel des Aerosols durch Thermophorese derart innerhalb des Aerosolstromes (10) gehalten werden, dass eine Abscheidung der Partikel an unerwünschten Stellen vermieden wird.

4. Verfahren zur Herstellung eines Aerosolstromes nach einem der vorhergehenden Ansprüche, dadurch gekennzeichnet, dass ein zu beschichtender Körper (40) während des Beschichtens gedreht wird und dass die Beschichtung in Abhängigkeit von Drehwinkel gesteuert und/oder geregelt wird durch Änderungen der Drehgeschwindigkeit und/oder der Dotierung des Aerosols und/oder der Feldstärke des elektrischen Feldes, welches die Abscheidung unterstützt.

5. Verfahren zur Herstellung eines Aerosolstromes nach einem der vorhergehenden Ansprüche, dadurch gekennzeichnet, dass auf dem Körper (40) glasige und/oder glasbildende Schichten abgeschieden werden zur Herstellung einer Vorform für einen Lichtwellenleiter.

6. Verfahren zur Herstellung eines Aerosolstromes nach einem der vorhergehenden Ansprüche, dadurch gekennzeichnet, dass auf dem Körper (40) vom Drehwinkel abhängige Schichten abgeschieden werden zur Herstellung einer Vorform für einen Lichtwellenleiter mit einem optisch nicht rotationssymmetrischem Querschnitt.

7. Verfahren zur Herstellung eines Aerosolstromes nach einem der vorhergehenden Ansprüche, dadurch gekennzeichnet, dass der Körper (40) im wesentlichen entlang einer Mantellinie beschichtet wird.

## Revendications

1. Procédé pour produire un courant d'aérosol, en particulier un courant d'aérosol contenant des particules de SiO$_2$ pour la préparation d'un moule préalable pour un conducteur d'ondes lumineuses, dans lequel

– les réactifs à l'état de gaz et/ou de vapeurs nécessaires pour la production du courant d'aérosol sont envoyés dans plusieurs tubes en disposition concentrique dans une chambre de réaction et

– la paroi de la chambre de réaction est chauffée de manière à éviter une déposition sur cette paroi des particules contenues dans le courant d'aérosol, caractérisé en ce que

– au moins un constituant des réactifs à l'état de gaz et/ou de vapeurs est chauffé avant introduction dans la chambre de réaction (1) à une température correspondant essentiellement à la température de réaction nécessaire pour la formation de l'aérosol,

– l'aérosol est produit dans une réaction chimique sans flamme,

– le courant d'aérosol formé est guidé par un courant de gaz et/ou de vapeurs (20) essentiellement exempt d'aérosol et

– le courant de gaz et/ou de vapeurs (20) essentiellement exempt d'aérosol est chauffé à une température supérieure à la température de réaction.

2. Procédé pour produire un courant d'aérosol selon la revendication 1, caractérisé en ce que la température plus élevée du courant de gaz et/ou de vapeurs exempt d'aérosol (20) est réglée à un niveau auquel les particules de l'aérosol sont maintenues par thermophorèse à l'intérieur du courant d'aérosol (10), évitant ainsi une déposition des particules à des endroits indésirables.

3. Procédé pour la production d'un courant d'aérosol selon la revendication 1 ou 2, caractérisé en ce que les parois environnant le courant d'aérosol (10) et/ou le courant de gaz et/ou de vapeurs (20) exempt d'aérosol sont chauffées à la température plus élevée et telle que les particules de l'aérosol soient maintenues par thermophorèse à l'intérieur du courant d'aérosol (10), évitant ainsi une déposition des particules à des endroits indésirables.

4. Procédé pour la production d'un courant d'aérosol selon l'une des revendications qui précèdent, caractérisé en ce que, au cours du revêtement, le corps à revêtir (40) est soumis à rotation et le revêtement est dirigé et/ou réglé en fonction de l'angle de rotation par des variations dans la vitesse de rotation et/ou dans le dopage de l'aérosol et/ou dans l'intensité du champ électrique qui assiste la déposition.

5. Procédé pour la production d'un courant d'aérosol selon l'une des revendications qui précèdent, caractérisé en ce que l'on dépose sur le corps (40) des couches vitreuses et/ou vitrifiables pour la préparation d'un moule préalable pour un conducteur d'ondes lumineuses.

6. Procédé pour la production d'un courant d'aérosol selon l'une des revendications qui précèdent, caractérisé en ce que l'on dépose sur le corps (40) des couches en fonction de l'angle de rotation pour la préparation d'un moule préalable pour un conducteur d'ondes lumineuses à section non symétrique par la rotation optique.

7. Procédé pour la production d'un courant d'aérosol selon l'une des revendications qui précèdent, caractérisé en ce que le corps (40) est revêtu essentiellement le long d'une génératrice.

**Claims**

1. Method for the production of an aerosol current, in particular an aerosol current containing particles of silicon dioxide for the production of a preform for an optical conductor, in which method

− the gaseous and/or vapourous reagents required for the production of the aerosol current are conducted in several concentrically arranged tubes to a reaction space and

− the wall of the reaction space is heated in such a manner that a deposition thereat of the particles contained in the aerosol current is avoided, characterised thereby,

− at least a component of the gaseous and/or vapourous reagents is heated before the introduction into the reaction space (1) to a temperature which corresponds substantially to the reaction temperature for the production of the aerosol,

− that the aerosol is produced by a flame-free chemical reaction,

− that the arisen aerosol current is conducted through a substantially aerosol-free gas and/or vapour current (20) and

− that the substantially aerosol-free gas and/or vapour current is heated to a temperature which is higher by comparison with the reaction temperature.

2. Method for the production of an aerosol current according to claim 1, characterised thereby, that the higher temperature of the aerosol-free gas and/or vapour current (20) is set to a value, at which the particles of the aerosol are held by thermophoresis within the aerosol current (10) in such a manner that a precipitation of the particles at undesired places is avoided.

3. Method for the production of an aerosol current according to claim 1 or claim 2, characterised thereby, that the walls surrounding the aerosol current (10) and/or the aerosol-free gas and/or vapour current (20) are heated to the higher temperature in such a manner that the particles of the aerosol are held by thermophoresis within the aerosol current (10) in such a manner that a precipitation of the particles at undesired placed is avoided.

4. Method for the production of an aerosol current according to one of the preceding claims, characterised thereby, that a body (40) to be coated is rotated during the coating and that the coating is controlled and/or regulated in dependence on the angle of rotation through changes in the speed of rotation and/or the doping of the aerosol and/or the field strength of the electric field which enhances the precipitation.

5. Method for the production of an aerosol current according to one of the preceding claims, characterised thereby, that vitreous and/or vitrifying layers are precipitated on the body (40) for the production of a preform for an optical conductor.

6. Method for the production of an aerosol current according to one of the preceding claims, characterised thereby, that layers dependent on the angle of rotation are precipitated on the body (40) for the production of a preform for an optical conductor with a cross-section which is optically not rotationally symmetrical.

7. Method for the production of an aerosol current according to one of the preceding claims, characterised thereby, that the body (40) is coated substantially along a generatrix.

0 169 325

1/ 1